(19)

Europäisches Patentamt
European Patent Office
Office européen des brevets

(11) **EP 4 317 547 A1**

(12) **EUROPEAN PATENT APPLICATION**
published in accordance with Art. 153(4) EPC

(43) Date of publication:
**07.02.2024 Bulletin 2024/06**

(21) Application number: **22775531.1**

(22) Date of filing: **22.03.2022**

(51) International Patent Classification (IPC):
*C30B 29/16* (2006.01)  *C30B 15/34* (2006.01)
*H01L 21/205* (2006.01)  *H01L 21/365* (2006.01)
*H01L 29/12* (2006.01)  *H01L 29/24* (2006.01)
*H01L 29/78* (2006.01)  *H01L 33/12* (2010.01)

(52) Cooperative Patent Classification (CPC):
**C30B 15/34; C30B 29/16; H01L 21/02107;
H01L 21/015; H01L 29/12; H01L 29/24;
H01L 29/78; H01L 33/12**

(86) International application number:
**PCT/JP2022/012972**

(87) International publication number:
**WO 2022/202747 (29.09.2022 Gazette 2022/39)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **24.03.2021 JP 2021049332**

(71) Applicant: **Orbray Co., Ltd.
Tokyo 123-8511 (JP)**

(72) Inventors:
• **NISHIGUCHI Kengo
Yuzawa-shi, Akita 012-0855 (JP)**
• **KOTAKI Toshiro
Yuzawa-shi, Akita 012-0855 (JP)**

(74) Representative: **Ostertag & Partner Patentanwälte
mbB
Azenbergstraße 35
70174 Stuttgart (DE)**

(54) **GA2O3-BASED SINGLE CRYSTAL SUBSTRATE AND METHOD FOR MANUFACTURING GA2O3-BASED SINGLE CRYSTAL SUBSTRATE**

(57)    Problem: To realize a $Ga_2O_3$-based single crystal substrate in which, even if an $Al_xGa_{(1-x)}N$ ($0 \leq x \leq 1$)-based semiconductor is laminated on a $Ga_2O_3$-based single crystal substrate, no cracks or delamination occurs in a semiconductor layer and/or the $Ga_2O_3$-based single crystal substrate, and a high-quality and homogeneous semiconductor film is obtained, and to provide a method of manufacturing the $Ga_2O_3$-based single crystal substrate, an $Al_xGa_{(1-x)}N$-based optical semiconductor device using the $Ga_2O_3$-based single crystal substrate and an $Al_xGa_{(1-x)}N$-based power semiconductor device.

Solution: A $Ga_2O_3$-based single crystal substrate having an amount of warpage of -50 $\mu$m or more and 50 $\mu$m or less (including 0 $\mu$m) on a main surface. A method of manufacturing a $Ga_2O_3$-based single crystal substrate, including processing a substrate from a $Ga_2O_3$-based single crystal grown according to an induction heating type single crystal growth method to have an amount of warpage of -50 $\mu$m or more and 50 $\mu$m or less (including 0 $\mu$m) on a main surface.

Fig. 1

**Description**

[Technical Field]

The present invention relates to a $Ga_2O_3$-based single crystal substrate and a method of manufacturing a $Ga_2O_3$-based single crystal substrate.

[Background Art]

In the past, attempts have been made to develop various electronic devices such as light emitting diodes (LED) and field effect transistors (FET) by laminating an $Al_xGa_{(1-x)}N$ ($0 \leq x \leq 1$)-based semiconductor on a gallium oxide ($Ga_2O_3$)-based single crystal substrate (for example, refer to PTL 1).

According to PTL 1, a low-temperature AlN buffer layer is first laminated on a $Ga_2O_3$-based single crystal substrate, a nitride semiconductor layer and the like are laminated on the buffer layer, and thus various device structures can be manufactured.

However, actually, when a low-temperature AlN buffer layer and then an $Al_xGa_{(1-x)}N$-based semiconductor layer are laminated on a $Ga_2O_3$-based single crystal substrate, since a thermal expansion coefficient and/or a lattice constant of the $Ga_2O_3$-based single crystal substrate are different from those of the $Al_xGa_{(1-x)}N$-based semiconductor layer, the $Al_xGa_{(1-x)}N$-based semiconductor layer and the $Ga_2O_3$-based single crystal substrate warp, the semiconductor layer and/or the substrate crack or delaminate when the semiconductor is laminated or when the temperature is returned to room temperature after lamination. Therefore, in many cases, it is not possible to laminate a high-quality and homogeneous $Al_xGa_{(1-x)}N$-based semiconductor layer.

Therefore, according to PTL 2, when a method of laminating an interface resistance reduction layer and then a stress alleviating layer on a low-temperature AlN buffer layer, and laminating an $Al_xGa_{(1-x)}N$-based semiconductor layer on the stress alleviating layer is used, the $Al_xGa_{(1-x)}N$-based semiconductor in which the occurrence of cracks in the semiconductor layer is effectively reduced can be obtained.

[Citation List]

[Patent Literature]

[PTL 1] Japanese Patent Application Publication No. 2014-199935
[PTL 2] Japanese Patent Application Publication No. 2017-157725

[Summary of Invention]

[Technical Problem]

However, even with the method described in PTL 2, cracks and delamination still remain, and the method is insufficient. In addition, it is not desirable to add a new semiconductor lamination process for the interface resistance reduction layer and the stress alleviating layer because the lamination process becomes complicated.

Currently, techniques for laminating a semiconductor on a $Ga_2O_3$-based single crystal substrate are under research and development. In the semiconductor lamination techniques, a crystal system to which single crystals belong is generally one of the most important basic elements. Main semiconductor single crystal substrates currently used in various semiconductor devices include, for example, Si substrates, GaAs substrates, SiC(4H) substrates, and sapphire substrates, and these crystal systems are cubic crystals, cubic crystals, hexagonal crystals, or trigonal crystals, all of which are highly symmetrical crystal systems, and have weak cleavability. On the other hand, since $Ga_2O_3$-based single crystals as new crystals belong to a monoclinic crystal system, which is a rare crystal system with low symmetry, they exhibit very strong cleavability and cracks and delamination are very likely to occur, and thus it has not been possible to use conventional semiconductor laminate techniques on them.

The present invention has been made in view of the above problems, and an object of the present invention is to realize a $Ga_2O_3$-based single crystal substrate in which, even if an $Al_xGa_{(1-x)}N$ ($0 \leq x \leq 1$)-based semiconductor is laminated on a $Ga_2O_3$-based single crystal substrate, no cracks or delamination occurs in a semiconductor layer and/or the $Ga_2O_3$-based single crystal substrate, and a high-quality and homogeneous semiconductor film is obtained, and to provide a method of manufacturing the $Ga_2O_3$-based single crystal substrate, an $Al_xGa_{(1-x)}N$-based optical semiconductor device using the $Ga_2O_3$-based single crystal substrate and an $Al_xGa_{(1-x)}N$-based power semiconductor device.

[Solution to Problem]

The present inventors conducted extensive studies and as a result, found that the above problems are solved by the present invention of the following [1] to [18].

[1] A $Ga_2O_3$-based single crystal substrate having an amount of warpage of -50 $\mu$m or more and 50 $\mu$m or less (including 0 $\mu$m) on a main surface.

[2] The $Ga_2O_3$-based single crystal substrate according to [1],
wherein the planar shape is a circular shape, and the circular shape has a diameter of 24 mm or more and 160 mm or less and a thickness of 0.1 mm or more and 2.0 mm or less.

[3] The $Ga_2O_3$-based single crystal substrate according to [1],
wherein the planar shape is a rectangular shape, and the rectangular shape has a long side of 15 mm or more and 150 mm or less and a thickness of 0.1 mm or more and 2.0 mm or less.

[4] The $Ga_2O_3$-based single crystal substrate according to [3],
wherein the rectangular shape is a square shape and at least one corner is chamfered.

[5] The $Ga_2O_3$-based single crystal substrate according to any one of [1] to [4],
wherein the main surface is any of the (100) plane, the (010) plane, the (001) plane, the (-201) plane, and the (101) plane.

[6] The $Ga_2O_3$-based single crystal substrate according to any one of [1] to [4],
wherein the main surface is a surface inclined in a range of 7° or less (excluding 0°) with respect to any of the (100) plane, the (010) plane, the (001) plane, the (-201) plane, and the (101) plane.

[7] The $Ga_2O_3$-based single crystal substrate according to any one of [1] to [6],
wherein the main surface is the (100) plane or a surface inclined in a range of 7° or less with respect to the (100) plane, and at least one end surface that is perpendicular to the main surface and is parallel to a b-axis or inclined within a range of 5° with respect to the b-axis is provided.

[8] The $Ga_2O_3$-based single crystal substrate according to any one of [1] to [6],
wherein the main surface is a surface other than the (100) plane or a surface other than the surface inclined in a range of 7° or less with respect to the surface other than the (100) plane, and at least one end surface that is perpendicular to the main surface and is parallel to the line of intersection between the main surface and the (100) plane or inclined within a range of 5° from the parallel direction is provided.

[9] The $Ga_2O_3$-based single crystal substrate according to any one of [1] to [8],
wherein the main surface has a dislocation density of 0 /cm$^2$ or more and $1 \times 10^5$ /cm$^2$ or less.

[10] The $Ga_2O_3$-based single crystal substrate according to any one of [1] to [9], containing one or more elements of Group 14 elements or Group 17 elements, which are n-type dopants, in a total range of 0.02 mol% or more and 0.15 mol% or less.

[11] The $Ga_2O_3$-based single crystal substrate according to any one of [1] to [9], containing one or more elements of Group 1 elements, Group 2 elements, Group 15 elements, or Fe, Cu, and Zn, which are p-type dopants, in a total range of 0.02 mol% or more and 0.15 mol% or less.

[12] The $Ga_2O_3$-based single crystal substrate according to any one of [1] to [11],
wherein an $Al_xGa_{(1-x)}N$ (0≤X≤1)-based semiconductor layer is formed on the main surface.

[13] The $Ga_2O_3$-based single crystal substrate according to any one of [1] to [11],
wherein a $Ga_2O_3$-based epitaxial layer or an AlGaN-based epitaxial layer is laminated and formed on the main surface.

[14] The $Ga_2O_3$-based single crystal substrate according to [13],
wherein the $Ga_2O_3$-based epitaxial layer or the AlGaN-based epitaxial layer has a thickness of 1 nm or more and 50 $\mu$m or less.

[15] The $Ga_2O_3$-based single crystal substrate according to [13] or [14],
wherein the $Ga_2O_3$-based epitaxial layer or the AlGaN-based epitaxial layer has a surface roughness Ra of 3 nm or less.

[16] A method of manufacturing a $Ga_2O_3$-based single crystal substrate, including
processing a substrate from a $Ga_2O_3$-based single crystal grown according to an induction heating type single crystal growth method to have an amount of warpage of -50 $\mu$m or more and 50 $\mu$m or less (including 0 $\mu$m) on a main surface.

[17] The method of manufacturing a $Ga_2O_3$-based single crystal substrate according to [16],
wherein a direction in which the $Ga_2O_3$-based single crystal is grown is any of a-axis, b-axis, and c-axis directions or a direction inclined in a range of 7° or less (excluding 0°) with respect to any of the a-axis, b-axis, and c-axis directions.

[18] The method of manufacturing a $Ga_2O_3$-based single crystal substrate according to [16] or [17],
wherein a $Ga_2O_3$-based epitaxial layer or an AlGaN-based epitaxial layer is formed on at least the main surface among all surfaces of the $Ga_2O_3$-based single crystal substrate.

[Effects of Invention]

It has been found that, when the $Ga_2O_3$-based single crystal substrate of the present invention is used as a base substrate, it is possible to eliminate cracks and/or delamination that occur during an $Al_xGa_{(1-x)}N$-based semiconductor lamination step, warpage during lamination can be kept low so that the substrate in-plane temperature distribution can be made uniform, and thus a high-quality and homogeneous $Al_xGa_{(1-x)}N$-based semiconductor laminate film can be grown. Therefore, for example, an $Al_xGa_{(1-x)}N$-based UV LED, which is one example of optical semiconductor device, can be manufactured with high quality, more UV LED elements can be obtained from one substrate, and thus the yield increases. Furthermore, it is possible to manufacture UV LEDs on large substrates, and thus the productivity is improved. In addition, the same applies to power semiconductor devices.

[Brief Description of Drawings]

[Fig. 1] Fig. 1 is a schematic cross-sectional view illustrating a growth furnace as an example of a method of manufacturing a $Ga_2O_3$-based single crystal according to an EFG method.

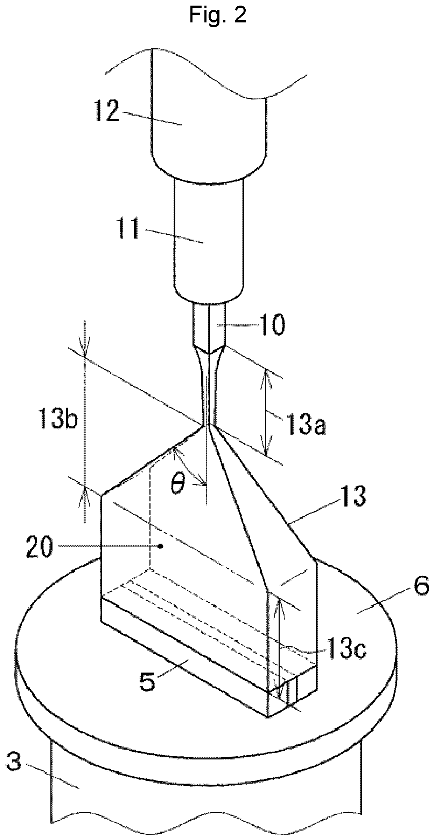

[Fig. 2] Fig. 2 is a diagram illustrating a method of manufacturing a $Ga_2O_3$-based single crystal according to an EFG method.
[Fig. 3] Fig. 3 shows perspective views of an example of a $Ga_2O_3$-based single crystal substrate according to an embodiment of the present invention.
[Fig. 4] Fig. 4 shows perspective views of another example of a $Ga_2O_3$-based single crystal substrate according to an embodiment of the present invention.
[Fig. 5] Fig. 5 is a diagram illustrating a measurement reference for SORI in the $Ga_2O_3$-based single crystal substrate in Fig. 3 and Fig. 4.
[Fig. 6] Fig. 6 is a diagram illustrating a measurement reference for BOW shown in Fig. 5.
[Fig. 7] Fig. 7 shows a structure of an UV LED (Example 3).
[Fig. 8] Fig. 8 shows a structure of a vertical MISFET (Example 4).

[Description of Embodiments]

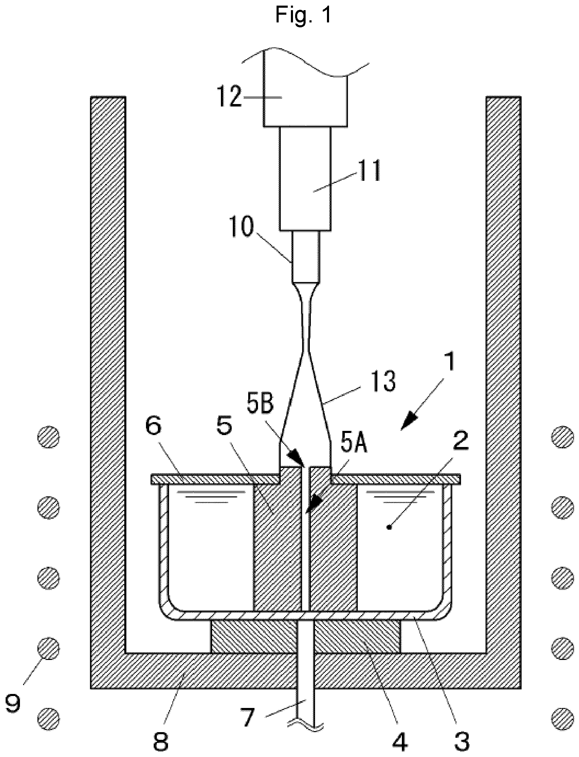

In the present embodiment, the $Ga_2O_3$-based is β-type $Ga_2O_3$ or β-$Ga_2O_3$ containing Al. When it contains Al, the crystal has a composition ratio of $(Al_{1-x}Ga_x)_2O_3$ (0<X≤1).
As an example of a method of growing a $Ga_2O_3$-based single crystal from which a substrate 16 or 21 is cut, an edge-defined film-fed growth (EFG) method may be exemplified. Fig. 1 is a schematic cross-sectional view showing a structure of a growth device 1 for a $Ga_2O_3$-based single crystal using the EFG method. The crystal growth method is not limited to the EFG method, and may be a Czochralski (CZ) method, a Bridgman method, or a flux method.
As shown in Fig. 1, a crucible 3 filled with a $Ga_2O_3$-based single crystal raw material is provided inside the growth device 1, and a die 5 provided with a slit 5A is installed in the crucible 3. A lid 6 is provided on the upper surface of the crucible 3 except for the part of the die 5.
Here, the $Ga_2O_3$ raw material to be used is $Ga_2O_3$ having a purity of 5 N (99.999%) or more and preferably a high purity of 6 N (99.9999%) or more, and having a high bulk density. In addition, various additives may be added to the raw material according to desired physical property values of the $Ga_2O_3$-based single crystal substrate (for example, an electrical resistivity, a carrier type, a carrier density, a mobility, a transmittance, a dislocation density, and the like). For example, as an n-type dopant, one or more elements of Groups 14 and 17 elements are introduced. Alternatively, as a p-type dopant, one or more elements of Group 1, 2, and 15 elements and Fe, Cu, and Zn are introduced.
The crucible 3, the die 5, the lid 6 and the like, which reach a high temperature of about 1,800°C or higher, which is a melting point of β-$Ga_2O_3$, and are exposed to the $Ga_2O_3$ melt or vapor, are made of a high-melting-point material that does not easily react with the $Ga_2O_3$ melt or vapor and has a heat resistance at a temperature higher than about 1,800°C. Currently, iridium is used because iridium is most suitable. Therefore, the growth atmosphere needs to be an inert atmosphere containing 100 Vol.% of an inert gas such as argon, nitrogen, or carbon dioxide, or an atmosphere containing about 10 Vol.% of oxygen. The crucible 3 may be pressurized to minimize evaporation of raw materials.
The crucible 3 is induction-heated to a predetermined temperature by a heater part 9 formed of an induction heating coil, the raw material in the crucible 3 is fused, and the melt rises through the slit 5A due to a capillary phenomenon.
Here, as a heating method for crystal growth, there is resistance heating that is generally used in the CZ method crystal growth of Si single crystals, but induction heating is more suitable for $Ga_2O_3$-based single crystal growth. This is because $Ga_2O_3$ has a property of being highly susceptible to sublimation and evaporation at a high temperature, and in the case of crystal growth by resistance heating in which the temperature in the entire hot zone should be raised to a high temperature, during growth, sublimation and/or decomposition and evaporation occur from seed crystals and/or grown crystals, and thus these crystals becomes narrow and thin, and in the worst case, all the crystals sublimate, decompose, evaporate and disappear. As a result, the yield of crystal growth is lowered or crystals cannot be grown. In contrast, in the case of induction heating, due to local heating in which only the iridium parts such as the crucible 3 and the lid 6 are heated to a high temperature, the crystals are relatively easy to cool, and sublimation and/or decomposition and evaporation from the crystal part are reduced to an almost negligible level. In addition, in the case of induction heating, since there is no wasteful heating, sublimation and/or evaporation from the crucible 3 are relatively reduced. As a result, the yield of crystal growth and the raw material utilization efficiency are improved. In addition, the amount of power consumption required for heating can be reduced.

First, a seed crystal 10 positioned above the slit 5A is lowered and partially comes into contact with a die upper surface part 5B to which a melt 2 is exposed. Then, by pulling up the seed crystal 10 at a predetermined speed, crystallization starts from the melt contact part of the seed crystal 10. The direction of pulling is the direction of crystal growth.

The temperature is raised as high as possible, and the seed crystal 10 is pulled while adjusting the pulling speed to form a narrow neck part for removing dislocations in the crystal (a necking 13a). Specifically, the growth temperature is 1,800°C or higher, and the thickness of the neck part is set to about half or less of the cross-sectional area of the seed crystal 10 in contact with the die upper surface part 5B. Based on the principle of crystal growth, in order to obtain single crystals with few dislocations, seed crystals having as few dislocations as possible are preferable.

Next, the rising speed of a seed crystal holder 11 is set to a predetermined speed, the growth temperature is lowered at a predetermined rate, and a $Ga_2O_3$-based single crystal 13 is grown around the seed crystal 10 to be widened at a certain angle $\theta$ in the width direction of the die 5 (spreading 13b). In order to grow single crystals with no twin crystal and having high crystallinity, it is preferable to make the change in the growth temperature as small as possible, and make $\theta°$ small, and to slow the spread. If $\theta°$ increases, since atoms in the melt rapidly align and crystallize, more twin crystals occur. Specifically, when the angle is 30° or less, twin crystals disappear and single crystals with high crystallinity can be grown.

However, regardless of the magnitude of $\theta$, when the impurity concentration in the single crystal is 0.02 mol% or more, twin crystals do not occur. When the impurity concentration is lower than 0.02 mol%, twin crystals occur. When the impurity concentration is higher than 0.15 mol%, twin crystals do not occur, but the crystallinity deteriorates. Therefore, the impurity concentration is preferably 0.15 mol% or less.

After the $Ga_2O_3$-based single crystal 13 spreads to the full width of the die 5, the part (a straight body part 13c) having the same width shape as the full width of the die 5 is pulled up to an appropriate length. For example, when a 2-inch substrate is manufactured, pulling is performed up to about 55 mm at 10 mm/hr. By the above necking, spreading, and growth of the straight body part, the dislocation density of the $Ga_2O_3$-based single crystal 13 can be reduced to $1.0 \times 10^5$ /cm$^2$ or less.

The pulling surface orientation can be set variously according to the surface orientation of the main surface. Regarding the direction of pulling, pulling is performed in any of a-axis, b-axis, and c-axis directions in which crystallization easily occurs during crystal growth and cracks, delamination, and chipping are less likely to occur during substrate processing or in any direction inclined in a range of 7° or less with respect to each axis. As a main surface 15 of the substrate 16 or 21, the (100) plane, the (010) plane, the (001) plane, the (101) plane, the (-201) plane or a surface inclined in an angle range within 7° (excluding 0°) with respect to any of the (100) plane, the (010) plane, the (001) plane, the (101) plane, and the (-201) plane is preferable because it allows a high-quality semiconductor layer with a favorable surface morphology to be formed on the main surface 15 and is suitable for manufacturing a device structure such as a UV LED.

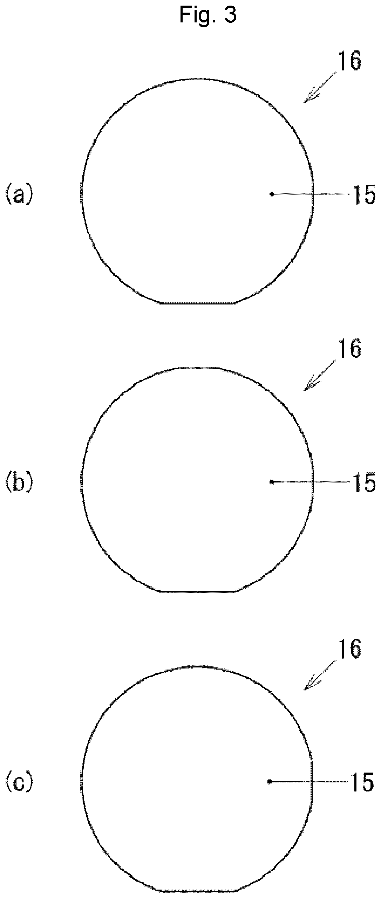

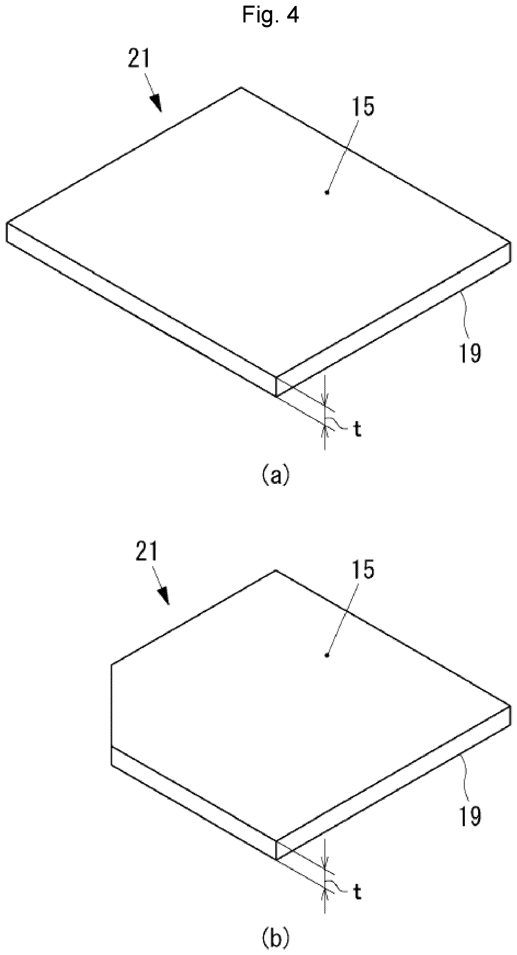

Next, a method of substrate-processing the grown $Ga_2O_3$-based single crystal 13 into a circular $Ga_2O_3$-based single crystal substrate 16 as shown in Fig. 3 or a rectangular shape 21 as shown in Fig. 4 will be described. For example, processing of cutting it into a circular shape or a rectangular shape is performed using a slicing machine, a core drill, an ultrasonic processing machine or the like, and a circular or rectangular substrate with a predetermined size is manufactured.

Then, the end surface of the substrate is shaped using an end surface grinder.

In addition, before and after the cutout processing, as necessary, an orientation flat may be formed on the substrate 16 or 21.

Regarding the orientation flat, when the main surface is the (100) plane or a surface included in a range of 7° or less with respect to the (100) plane, an end surface in a direction that is perpendicular to the main surface and is parallel to the b-axis or inclined within a range of 5° from the b-axis is provided as an orientation flat. When the main surface is a surface other than the (100) plane or a surface other than the surface inclined in a range of 7° or less with respect to the (100) plane, an end surface in a direction that is perpendicular to the main surface and is parallel to the line of intersection between the main surface and the (100) plane or inclined in a range of 5° in the parallel direction is provided.

Then, one or more orientation flats may be provided on the main surface as shown in Fig. 3(b).

When the rectangular substrate is a square, one or more chamfered corner parts may be provided using the end surface of the part obtained by chamfering the corner as an orientation flat as shown in Fig. 4(b).

When the orientation flat is formed in the above crystal orientation, it is possible to prevent cracks, chipping, and delamination from occurring in the substrate during processing, and it is possible to easily identify the crystal orientation of the substrate.

Next, one surface of the manufactured substrate 16 or 21 is set as the main surface 15, the main surface 15 is subjected to polishing processing such as wrapping and policing, and the main surface 15 is made ultra-flat. In addition, a back surface 19 is also subjected to polishing processing, as necessary, for the shape, and at the same time, the thickness of the substrate 16 or 21 is adjusted. Silicon carbide or alumina is used as abrasive grains for wrapping. Chemical mechanical polishing (CMP) is used as polishing and colloidal silica is used as CMP abrasive grains.

According to the above , the surface roughness Ra of the main surface 15 becomes 3.0 nm or less, and the surface roughness Ra of the back surface 19 becomes a roughness of 0.1 nm or more, as necessary.

After the above polishing processing is completed, dust such as silica adhering to the substrate is removed, and in order to remove and adjust the residual processing strain and to form a clean oxide layer on the surface of the substrate, after organic washing with acetone or the like, washing with hydrofluoric acid, and additionally, washing with RCA are performed entirely or partially.

In addition, in the above substrate processing process, a heat treatment for removing the residual heat strain, the residual processing strain, and coloring and for improving electrical characteristics, which is common for those skilled in the fields of processing substrates such as Si, GaAs, and sapphire single crystals, is appropriately performed. For the atmosphere gas for the heat treatment, excluding a reducing gas such as hydrogen gas, which has an effect of roughening the surface of the substrate, any of nitrogen, carbon dioxide, argon, oxygen, and air may be used or appropriate combinations thereof may be used. The treatment temperature is 500°C to 1,600°C and preferably 700 to 1,400°C. In addition, pressurization may be performed.

The shape of the substrate in the planar direction is a rectangular shape, a circular shape, or a rectangular or circular shape with an orientation flat.

In order to prevent cracks and delamination from occurring even if the $Al_xGa_{(1-x)}N$-based semiconductor film is laminated on the substrate, precisely control the shape, secure the rigidity of a self-supporting substrate at the same time, and have a strength that does not cause problems in handling, and also in order to make it possible to prevent the occurrence of cracks, delamination, and chipping, the long side is preferably 15 mm or more and 150 mm or less in the case of the above rectangular shape, and the diameter $\varphi$ is preferably 25 mm or more and $\varphi$160 mm or less in the case of each of the above circular shapes.

For the same reason as above, the thickness of the substrate is preferably 0.10 mm or more and 2.0 mm or less.

According to the substrate processing including a heat treatment and substrate washing for the substrate 16 or 21 as described above, the amount of warpage of the main surface 15 is within the above range. As necessary, the substrate may be subjected to internal modification processing with a laser, and the amount of warpage described above may be achieved.

Here, the amount of warpage is the absolute value of the SORI (according to SEMI standards) value, and defined as having a sign of $\pm$ indicating the direction of warpage. The sign of $\pm$ can be obtained from the cross-sectional view of the SORI measurement results, BOW measurement and the like, and when the substrate surface center position is above the reference plane, the sign is + (convex shape), and when it is below the reference plane, the sign is - (concave shape).

The above SORI and BOW are obtained using a flatness measurement device. For example, an optical interference type measurement device (commercially available from NIDEK) is used. The measurement is as follows.

First, a least squares plane based on all height data on the main surface 15 is the reference plane S.

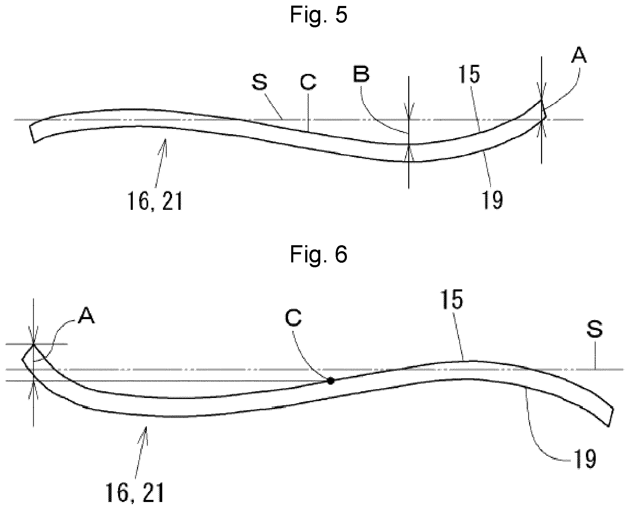

As shown in Fig. 5, the SORI is a total vertical distance (absolute value) between the highest point and the lowest point from the reference plane S on the surface when the back surface of the substrate 16 or 21 is fixed by suction at 1 point to 3 points with a suction chuck (not shown) (non-suction). Since the SORI is a sum of absolute values of the vertical distances between the highest point and the lowest point, the SORI is always a positive value. When the vertical distance from the reference plane S to the highest point is A, and the vertical distance from the reference plane S to the lowest point is B, the SORI is defined according to the following Equation 1.

[Math. 1]

$$SORI = |A| + |B|$$

Therefore, for example, in the case of Fig. 5, the amount of warpage is - (|A|+|B|).

The SORI value is the same as a so-called Peak to Valley (PV) value when the least squares plane on the main surface 15 is used as the reference surface.

As shown in Fig. 6, the BOW is a value obtained by summing the absolute values of the distance between the point with a sign different from that of the substrate center C and with the largest absolute value (excluding the center C) on the surface and the center C, and adding the sign of the center C as shown in Fig. 6 when the back surface of the substrate 16 is suctioned at 1 point to 3 points (non-suction). The side above the reference plane S is the positive side, and the side below the reference plane S is the negative side. In Fig. 6, the center C is positioned below the reference plane S, and thus the BOW has a negative value.

The dislocation density of the above substrate 16 or 21 cut from the single crystals grown by the EFG method and subjected to substrate processing is $1.0 \times 10^5$ /cm$^2$ or less. When a semiconductor layer is laminated on the substrate 16 or 21 with such a low dislocation density to manufacture, for example, an LED, it is possible to improve the light emitting efficiency and/or the device lifespan. In addition, for example, if the substrate 16 or 21 with a low dislocation density is used for a power device, it is possible to improve the power conversion efficiency and/or the device lifespan.

The above dislocation density is measured with a transmission electron microscope (TEM). In addition, since the dot-like etch pit density when the substrate is etched corresponds to the dislocation density, it may be evaluated by etching.

Next, as an example of laminating a semiconductor on the main surface 15 of the substrate 16 or 21, a metal organic chemical vapour deposition (MOCVD) method will be described. The lamination method is not limited to the MOCVD method, and a molecular beam epitaxy (MBE) method, a pulse laser deposition (PLD) method, a hydride vapour phase epitaxy (HVPE) method or the like may be used for growth. In order to obtain an $Al_xGa_{(1-x)}N$ semiconductor laminate film with favorable crystallinity, first, an $Al_xGa_{(1-x)}N$ buffer layer is grown at a growth temperature of 500 to 900°C to a thickness of 1 to 200 nm.

Next, an $Al_xGa_{(1-x)}N$ semiconductor layer is grown on the buffer layer, for example, at 800 to 1,100°C to a thickness of 100 um or less, and the temperature is lowered after the growth is completed.

After the temperature reaches around ordinary temperature, the $Ga_2O_3$-based single crystal substrate on which the $Al_xGa_{(1-x)}N$-based semiconductor is laminated is taken out, and quality evaluation of cracks and/or delamination is performed visually and using an optical microscope.

According to the above embodiment, when a $Ga_2O_3$-based single crystal substrate in which the amount of warpage of the main surface is within the above range is used as a base substrate, it is possible to eliminate cracks and/or delamination occurring in the $Al_xGa_{(1-x)}N$-based semiconductor lamination step. In addition, at the same time, since the amount of warpage during lamination can be kept low, the substrate in-plane temperature distribution can be made uniform, and thus a high-quality and homogeneous $Al_xGa_{(1-x)}N$-based semiconductor laminate can be grown.

Therefore, for example, an $Al_xGa_{(1-x)}N$-based UV LED, which is one example of optical semiconductor device, can be manufactured with high quality, more UV LED elements can be obtained from one substrate, and thus the yield increases. Furthermore, it is possible to manufacture UV LEDs on large substrates, and thus the productivity is improved. In addition, the same applies to power semiconductor devices.

On the other hand, when a $Ga_2O_3$-based single crystal substrate in which the amount of warpage is outside the above range is used as a base substrate, cracks and/or delamination occur in the $Al_xGa_{(1-x)}N$-based semiconductor lamination step. In addition, since the amount of warpage increases during lamination and the substrate in-plane temperature distribution becomes non-uniform, it is not possible to grow a high-quality and homogeneous $Al_xGa_{(1-x)}N$-based semiconductor laminate film.

A $Ga_2O_3$-based epitaxial layer or an AlxGa(1-x)N-based epitaxial layer may once be laminated and formed on all surfaces or at least the main surface 15 of the substrate 16 or 21 by the MOCVD method, the HVPE method or the like. When a $Ga_2O_3$-based epitaxial layer is laminated and formed, if it is laminated on the main surface 15 to a thickness of 50 um or less, crystal defects are reduced, and the Ra value becomes even smaller than the surface roughness Ra of the main surface 15. Accordingly, a higher-quality $Al_xGa_{(1-x)}N$ layer can be laminated and formed on the $Ga_2O_3$-based epitaxial layer. In the case of the AlxGa(1-x)N-based epitaxial layer, if it is laminated to a thickness of 1 nm or more, the resistance of the $Ga_2O_3$-based single crystal substrate to a hydrogen carrier gas which is essential for general nitride-based semiconductor growth is improved, and deterioration of the substrate is suppressed. Therefore, a desired high-quality $Al_xGa_{(1-x)}N$-based semiconductor layer can be grown on the $Ga_2O_3$-based single crystal substrate. Then, not only the $Al_xGa_{(1-x)}N$-based semiconductor layer but also the $Al_xGa_{(1-x)}N$-based semiconductor laminate including the substrate 16 or 21 can be obtained with high quality.

Furthermore, in place of the $Al_xGa_{(1-x)}N$-based epitaxial layer, the surface of the substrate 16 or 21 may be nitrided.

Examples according to the present invention will be described below, but the present invention is not limited only to the following Examples.

(Example 1)

Ga$_2$O$_3$-based single crystal substrates according to Example Samples 1 to 7 were formed by cutting out with a core drill from single crystals grown by b-axis pulling according to the EFG method. Common conditions for Example Samples 1 to 7 are as follows. All the shapes of the substrates in the planar direction were circular shapes with one orientation flat surface as shown in Fig. 3, and the Ga$_2$O$_3$-based single crystal forming the substrate was a β-Ga$_2$O$_3$ single crystal, doped with 0.05 mol% of Si. Furthermore, the Ga$_2$O$_3$-based single crystal substrate had a diameter of φ2 inches, had a main surface that was the (101) plane with an off angle of 0.0°, a thickness of 0.70 mm, a main surface dislocation density of $4 \times 10^4$ /cm$^2$, and no twin crystals.

The cut-out substrate was heated and the outer shape of the substrate was then shaped using a surface grinder. Then, the back surface of the substrate was wrapped alone or wrapped and polished as in the main surface. Then, the main surface of the substrate was subjected to wrapping and polishing. After polishing was completed, organic washing, washing with hydrofluoric acid, and washing with RCA were performed.

By changing conditions for processing (polishing processing, heat treatment, substrate washing, and internal modification processing) performed on the main surface and the back surface for example samples, the amounts of warpage of the Ga$_2$O$_3$-based single crystal substrates of the example samples were formed as shown in Table 1.

[Table 1]

| Sample | Amount of warpage | Cracks, delamination [locations] |
|---|---|---|
| 1 | -44 | 0 |
| 2 | -32 | 0 |
| 3 | -6 | 0 |
| 4 | -4 | 0 |
| 5 | 3 | 0 |
| 6 | 9 | 0 |
| 7 | 43 | 0 |

(Comparative Example 1)

In addition, as Comparative Example Samples 1 and 2, the Ga$_2$O$_3$-based single crystal substrates were processed in the similar manner as in Example 1 and the amounts of warpage were obtained as shown in Table 2.

[Table 2]

| Sample | Amount of warpage | Cracks, de lamination [locations] |
|---|---|---|
| 1 | -67 | 2 |
| 2 | 62 | 5 |

On the main surface of each Ga$_2$O$_3$-based single crystal substrate of Example Samples 1 to 7 and Comparative Example Samples 1 and 2, an AlN buffer layer was grown at 550°C to a thickness of 3 nm by the MOCVD method and an Si-doped n-type Al0.4Ga0.6N composition crystal was then grown at 1,050°C to a thickness of 4 um. Then, the temperature was lowered and the sample was taken out from the device after the temperature reached ordinary temperature. When X-ray diffraction (XRD) measurement of the Al0.4Ga0.6N film was performed, the entire main surface of all samples was the (0001) plane, and epitaxial growth was performed. As a result of quality evaluation, it was confirmed that neither the Al0.4Ga0.6N layer nor the Ga$_2$O$_3$-based single crystal substrate had cracks or delamination in Examples 1 to 7.

On the other hand, in both of Comparative Example Samples 1 and 2, it was confirmed that cracks or delamination occurred in the Al$_{0.4}$Ga$_{0.6}$N layer or the Ga$_2$O$_3$-based single crystal substrate.

(Example 2)

Ga$_2$O$_3$-based single crystal substrates according to Example Samples 8 to 14 were formed by cutting out to 20 mm×30 mm rectangles with a slicing machine from single crystals grown by b-axis pulling according to the EFG method. Common conditions for Example Samples 8 to 14 are as follows. All the shapes of the substrates in the planar direction were a rectangular shape, and the $Ga_2O_3$-based single crystal forming the substrate was a β-$Ga_2O_3$ single crystal, doped with 0.05 mol% of Si. Furthermore, the $Ga_2O_3$-based single crystal substrate had a main surface that was the (101) plane with an off angle of 0.0°, a thickness of 0.70 mm, a main surface dislocation density of $4 \times 10^4$/cm², and no twin crystals.

Then, the $Ga_2O_3$-based single crystal substrates were processed in the similar manner as in Example 1 and the amounts of warpage were obtained as shown in Table 3.

[Table 3]

| Sample | Amount of warpage | Cracks,delamination [locations] |
|---|---|---|
| 8 | -41 | O |
| 9 | -17 | O |
| 10 | -5 | O |
| 11 | 3 | O |
| 12 | 4 | O |
| 13 | 6 | O |
| 14 | 35 | O |

(Comparative Example 2)

In addition, as Comparative Example Samples 3 and 4, the $Ga_2O_3$-based single crystal substrates were processed in the similar manner as in Example 2, and the amounts of warpage were obtained as shown in Table 4.

[Table 4]

| Sample | Amount of warpage | Cracks,delamination [locations] |
|---|---|---|
| 3 | 53 | 4 |
| 4 | 56 | 7 |

On the main surface of each $Ga_2O_3$-based single crystal substrate of Example Samples 8 to 14 and Comparative Example Samples 3 and 4, in the similar manner as in Example 1, an AlN buffer layer and n-type $Al_{0.4}Ga_{0.6}N$ composition crystals were then grown, the temperature was lowered and the sample was then taken out. From X-ray diffraction (XRD) measurement of the $Al_{0.4}Ga_{0.6}N$ film, it was confirmed that the entire main surface of all samples was the (0001) plane, and epitaxial growth was performed. As a result of quality evaluation, it was confirmed that neither the $Al_{0.4}Ga_{0.6}N$ layer nor the $Ga_2O_3$-based single crystal substrate had cracks or delamination in Examples 8 to 14.

On the other hand, it was confirmed that, in both of Comparative Example Samples 3 and 4, either cracks or delamination occurred in the n-type $Al_{0.4}Ga_{0.6}N$ layer or the $Ga_2O_3$-based single crystal substrate.

As described above, from Examples 1 and 2 and Comparative Examples 1 and 2, when the substrate 16 or 21 in which the amount of warpage was within a range of -50 μm or more and +50 μm or less was used as a base substrate when the $Al_{(1-x)}Ga_xN$-based semiconductor was laminated, it was possible to eliminate cracks and delamination. In addition, at the same time, since the substrate in-plane temperature distribution during lamination could be uniform, a high-quality and homogeneous $Al_{(1-x)}Ga_xN$-based semiconductor laminate film could be grown on the main surface.

(Example 3)

Among the samples of Example 1, a vertical UV LED as an optical device was manufactured by duplicating a sample under the same conditions as Sample 4 in which cracks and delamination did not occur.

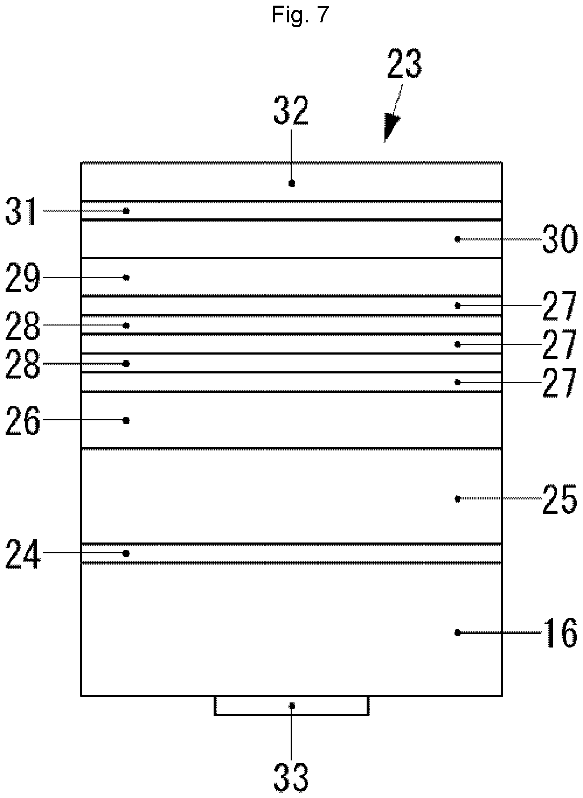

Fig. 7 shows an example of a laminate structure of a vertical UV LED 23. First, on the n-type $Al_{0.4}Ga_{0.6}N$ layer 25, an $InAl_{0.4}Ga_{0.6}N$ layer 26 which was a Si-doped n-type clad layer, was grown at 1,000°C to a thickness of 25 nm by the MOCVD method. In was added to improve the light emitting efficiency, and its composition ratio was less than 1%.

Next, in order to emit light at a wavelength of 300 nm for a light emitting layer, an $InAl_{0.5}Ga_{0.5}N$ barrier layer 27 was grown at 1,050°C to a thickness of 6 nm, an $InAl_{0.3}Ga_{0.7}N$ quantum well layer 28 was grown at 1,050°C to a thickness of 2 nm, and a multi-layer structure in which the barrier layer and the quantum well layer were alternately grown was grown in three layers as shown in Fig. 7.

Next, an Mg-doped p-type $InAl_{0.6}Ga_{0.4}N$ electron blocking layer 29 was grown at 1,050°C to a thickness of 20 nm.

Next, an Mg-doped p-type $InAl_{0.5}Ga_{0.5}N$ clad layer 30 was grown at 1,050°C to a thickness of 20 nm.

Next, an Mg-doped p-type $InAl_{0.3}Ga_{0.7}N$ contact layer 31 was grown at 1,000°C to a thickness of 10 nm.

Next, as a p-side electrode 32, a Ni/Al laminate structure that provided ohmic contact and highly reflected ultraviolet rays coming from the light emitting layer was formed on the p-type contact layer 31.

In addition, as an n-side electrode 33, a Ti/Au laminate structure that came into ohmic contact with the $Ga_2O_3$-based single crystal substrate 16 and highly transmitted ultraviolet rays coming from the side of the light emitting layer was formed.

When a current flowed through the n-side electrode 33 and the p-side electrode 32, the UV LED 23 emitted ultraviolet rays from the side of the n-side electrode 33.

As described above, when the $Ga_2O_3$-based single crystal substrate 16 in which the amount of warpage was within a predetermined range was used, the vertical UV LED 23, which could not be realized on the sapphire substrate, could be realized with high quality without causing cracks or delamination. Furthermore, it was possible to manufacture the vertical UV LED 23 on large substrates, and thus the productivity could be improved.

(Example 4)

Among the samples of Example 1, a vertical metal-insulator-semiconductor field effect transistor (MISFET) as a high-withstand-voltage power device was manufactured by duplicating a sample under the same conditions as Sample 5 in which cracks and delamination did not occur.

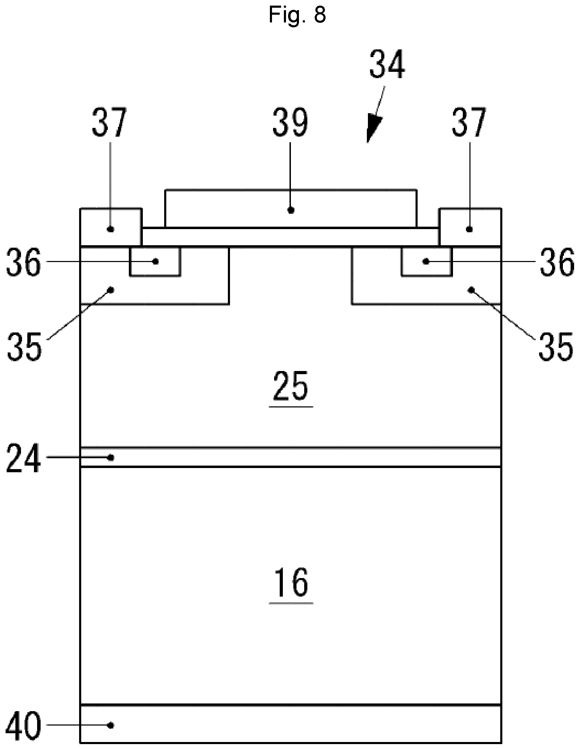

Fig. 8 shows an example of a laminate structure of a vertical MISFET 34. First, N ions were implanted into the n-type $Al_{0.4}Ga_{0.6}N$ layer 25 using an ion implantation device to form a p-type region 35.

Next, Si ions were implanted into the p-type region 35 to form an n+type region 36.

Above the p-type region 35 and the n+region 36, a source electrode 37 having a Ti/Al laminate structure was formed by a deposition device as shown in Fig. 8. In addition, above the n-$Al_{0.4}Ga_{0.6}N$ layer 25 and the p-type region 35, and the n+type region 36, by a deposition device, Al2O3 as a gate insulator 38 was formed and a gate electrode 39 was formed with Al on the gate insulator 38.

On the other hand, a drain electrode 40 having a Ti/Al laminate structure was formed on the side of $Ga_2O_3$-based single crystals and completed.

In this manner, when the substrate 16 in which the amount of warpage was within a range of -50 μm or more and +50 μm or less was used, it was possible to manufacture the high-withstand voltage-vertical MISFET 34 in which the $Al_{(1-x)}Ga_xN$-based semiconductor was laminated without cracks or delamination. In addition, it was possible to manufacture the vertical MISFET 34 on large substrates and the productivity could be improved.

While the invention implemented by the present inventors has been described above in detail, the present invention is not limited to the embodiments and examples described above, and many modifications can be made within the technical idea of the present invention by those skilled in the art.

Here, the scope of the present invention is determined to the full extent allowed by the law according to the broadest permissible interpretation of the claims and their equivalents, and is not restricted or limited by the above detailed descriptions.

[Reference Signs List]

| | |
|---|---|
| 1 | Growth device |
| 2 | Melt containing $Ga_2O_3$ |
| 3 | Crucible |
| 4 | Support stand |
| 5 | Die |
| 5A | Slit |
| 5B | Die upper surface part |
| 6 | Lid |
| 7 | Thermocouple |
| 8 | Heat insulating material |
| 9 | Heater part |
| 10 | Seed crystal |
| 11 | Seed crystal holder |

12 Shaft
13 $Ga_2O_3$-based single crystal
13a Neck part or necking
13b Spreading
13c Straight body part
14 First orientation flat surface
15 Main surface of $Ga_2O_3$-based single crystal substrate
16, 21 $Ga_2O_3$-based single crystal substrate
17 Second orientation flat surface
19 Back surface of $Ga_2O_3$-based single crystal substrate
20 Surface of $Ga_2O_3$-based single crystal
22 Region near periphery of circular $Ga_2O_3$-based single crystal substrate
23 Vertical UV LED
24 AlN buffer layer
25 n-type $Al_{0.4}Ga_{0.6}N$ layer
26 $InAl_{0.4}Ga_{0.6}N$ layer
27 $InAl_{0.5}Ga_{0.5}N$ barrier layer
28 $InAl_{0.3}Ga_{0.7}N$ quantum well layer
29 Mg-doped p-type $InAl_{0.6}Ga_{0.4}N$ electron blocking layer
30 Mg-doped p-type $InAl_{0.5}Ga_{0.5}N$ clad layer
31 Mg-doped p-type $InAl_{0.3}Ga_{0.7}N$ contact layer
32 p-side electrode
33 n-side electrode
34 Vertical MISFET
35 p-type region
36 n+type region
37 Source electrode
38 Gate insulator
39 Gate electrode
40 Drain electrode
A Vertical distance from reference plane S of $Ga_2O_3$-based single crystal substrate to highest point
B Vertical distance from reference plane S of $Ga_2O_3$-based single crystal substrate to the lowest point
C Main surface center of $Ga_2O_3$-based single crystal substrate
S least squares plane on main surface of $Ga_2O_3$-based single crystal substrate
t Thickness of $Ga_2O_3$-based single crystal substrate
$\theta$ Spreading angle

**Claims**

1. A $Ga_2O_3$-based single crystal substrate,
which has an amount of warpage of -50 $\mu$m or more and 50 $\mu$m or less (including 0 $\mu$m) on a main surface.

2. The $Ga_2O_3$-based single crystal substrate according to claim 1,
wherein a planar shape is a circular shape, and the circular shape has a diameter of 24 mm or more and 160 mm or less and a thickness of 0.1 mm or more and 2.0 mm or less.

3. The $Ga_2O_3$-based single crystal substrate according to claim 1,
wherein a planar shape is a rectangular shape, and the rectangular shape has a long side of 15 mm or more and 150 mm or less and a thickness of 0.1 mm or more and 2.0 mm or less.

4. The $Ga_2O_3$-based single crystal substrate according to claim 3,
wherein the rectangular shape is a square shape and at least one corner is chamfered.

5. The $Ga_2O_3$-based single crystal substrate according to any one of claims 1 to 4,
wherein the main surface is any of a (100) plane, a (010) plane, a (001) plane, a (-201) plane, and a (101) plane.

6. The $Ga_2O_3$-based single crystal substrate according to any one of claims 1 to 4,

wherein the main surface is a surface inclined in a range of 7° or less (excluding 0°) with respect to any of a (100) plane, a (010) plane, a (001) plane, a (-201) plane, and a (101) plane.

7. The $Ga_2O_3$-based single crystal substrate according to any one of claims 1 to 4,
    wherein the main surface is a (100) plane or a surface inclined in a range of 7° or less with respect to the (100) plane, and at least one end surface that is perpendicular to the main surface and is parallel to a b-axis or inclined within a range of 5° with respect to the b-axis is provided.

8. The $Ga_2O_3$-based single crystal substrate according to any one of claims 1 to 4,
    wherein the main surface is a surface other than a (100) plane or a surface other than a surface inclined in a range of 7° or less with respect to a surface other than the (100) plane, and at least one end surface that is perpendicular to the main surface and is parallel to a line of intersection between the main surface and the (100) plane or inclined within a range of 5° from a parallel direction is provided.

9. The $Ga_2O_3$-based single crystal substrate according to any one of claims 1 to 8,
    wherein the main surface has a dislocation density of 0 /cm$^2$ or more and $1 \times 10^5$ /cm$^2$ or less.

10. The $Ga_2O_3$-based single crystal substrate according to any one of claims 1 to 9,
    which comprises one or more elements of Group 14 elements or Group 17 elements, which are n-type dopants, in a total range of 0.02 mol% or more and 0.15 mol% or less.

11. The $Ga_2O_3$-based single crystal substrate according to any one of claims 1 to 9,
    which comprises one or more elements of Group 1 elements, Group 2 elements, Group 15 elements, or Fe, Cu, and Zn, which are p-type dopants, in a total range of 0.02 mol% or more and 0.15 mol% or less.

12. The $Ga_2O_3$-based single crystal substrate according to any one of claims 1 to 11,
    wherein an $Al_xGa_{(1-x)}N$ ($0 \leq X \leq 1$)-based semiconductor layer is formed on the main surface.

13. The $Ga_2O_3$-based single crystal substrate according to any one of claims 1 to 11,
    wherein a $Ga_2O_3$-based epitaxial layer or an AlGaN-based epitaxial layer is laminated and formed on the main surface.

14. The $Ga_2O_3$-based single crystal substrate according to claim 13,
    wherein the $Ga_2O_3$-based epitaxial layer or the AlGaN-based epitaxial layer has a thickness of 1 nm or more and 50 $\mu$m or less.

15. The $Ga_2O_3$-based single crystal substrate according to claim 13 or 14,
    wherein the $Ga_2O_3$-based epitaxial layer or the AlGaN-based epitaxial layer has a surface roughness Ra of 3 nm or less.

16. A method of manufacturing a $Ga_2O_3$-based single crystal substrate, comprising
    processing a substrate from a $Ga_2O_3$-based single crystal grown according to an induction heating type single crystal growth method to have an amount of warpage of -50 $\mu$m or more and 50 $\mu$m or less (including 0 $\mu$m) on a main surface.

17. The method of manufacturing a $Ga_2O_3$-based single crystal substrate according to claim 16,
    wherein a direction in which the $Ga_2O_3$-based single crystal is grown is any of a-axis, b-axis, and c-axis directions or a direction inclined in a range of 7° or less (excluding 0°) with respect to any of the a-axis, b-axis, and c-axis directions.

18. The method of manufacturing a $Ga_2O_3$-based single crystal substrate according to claim 16 or 17,
    wherein a $Ga_2O_3$-based epitaxial layer or an AlGaN-based epitaxial layer is formed on at least the main surface among all surfaces of the $Ga_2O_3$-based single crystal substrate.

Fig. 1

## Fig. 2

## Fig. 3

(a)

16

15

(b)

16

15

(c)

16

15

## Fig. 4

(a)

(b)

Fig. 5

Fig. 6

Fig. 7

23

32

31

30

29

27

28

27

28

27

26

25

24

16

33

Fig. 8

## INTERNATIONAL SEARCH REPORT

| | International application No. |
|---|---|
| | **PCT/JP2022/012972** |

**A.    CLASSIFICATION OF SUBJECT MATTER**

*C30B 29/16*(2006.01)i; *C30B 15/34*(2006.01)i; *H01L 21/205*(2006.01)i; *H01L 21/365*(2006.01)i; *H01L 29/12*(2006.01)i;
*H01L 29/24*(2006.01)i; *H01L 29/78*(2006.01)i; *H01L 33/12*(2010.01)i
FI:   C30B29/16; C30B15/34; H01L33/12; H01L29/78 652T; H01L29/78 652K; H01L29/24; H01L21/205; H01L21/365

According to International Patent Classification (IPC) or to both national classification and IPC

**B.    FIELDS SEARCHED**

Minimum documentation searched (classification system followed by classification symbols)

C30B29/16; C30B15/34; H01L21/205; H01L21/365; H01L29/12; H01L29/24; H01L29/78; H01L33/12

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| X | JP 2016-13934 A (TAMURA SEISAKUSHO KK) 28 January 2016 (2016-01-28) claims 1-6, paragraphs [0016]-[0085], fig. 3-6 | 1-2, 5, 9, 12-14, 16, 18 |
| Y | | 3-4, 6-8, 10-11, 15, 17 |
| Y | JP 2000-211993 A (MITSUBISHI ELECTRIC CORP) 02 August 2000 (2000-08-02) paragraph [0027], fig. 2 | 3-4, 6-8, 10-11, 15, 17 |
| A | | 1-2, 5, 9, 12-14, 16, 18 |
| Y | JP 2016-13931 A (TAMURA SEISAKUSHO KK) 28 January 2016 (2016-01-28) paragraphs [0054]-[0057] | 6-8, 10-11, 15, 17 |
| A | | 1-5, 9, 12-14, 16, 18 |

| ☐ Further documents are listed in the continuation of Box C. | ☑ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **10 May 2022** | **24 May 2022** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
**Information on patent family members**

| International application No. |
| --- |
| **PCT/JP2022/012972** |

| Patent document cited in search report | | | Publication date (day/month/year) | Patent family member(s) | Publication date (day/month/year) |
| --- | --- | --- | --- | --- | --- |
| JP | 2016-13934 | A | 28 January 2016 | US 2015/0380501 A1<br>claims 1-3, 5, 13-14,<br>paragraphs [0020]-[0089]<br>KR 10-2016-0002323 A<br>TW 201601341 A | |
| JP | 2000-211993 | A | 02 August 2000 | US 2001/0010112 A1<br>paragraph [0090], fig. 2 | |
| JP | 2016-13931 | A | 28 January 2016 | US 2017/0152610 A1<br>paragraphs [0074]-[0077]<br>EP 3162922 A1<br>TW 201606147 A<br>CN 106471164 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014199935 A

- JP 2017157725 A